# EUROPÄISCHE PATENTSCHRIFT

(11) **EP 1 162 735 B1**
(45) Veröffentlichungstag und Bekanntmachung des Hinweises auf die Patenterteilung: **29.02.2012**
(21) Anmeldenummer: 01890174.4
(22) Anmeldetag: 06.06.2001
(51) Int. Cl.: H03F 3/217

(54) **Verfahren und Vorrichtung zur Erzeugung einem Eingangs-Datenstrom folgenden Wechselspannung**
Method and apparatus for producing an alternating voltage from an input data stream
Procédé et dispositif pour produire une tension alternative d'un flux de données d'entrée

(30) Priorität: 07.06.2000 AT 9962000
(43) Veröffentlichungstag der Anmeldung: 12.12.2001
(73) Patentinhaber: Günther, Bier, 1200 Wien (DE)
(72) Erfinder: Bier, Günther, Ing., 1200 Wien (AT); Bruckner, Florian, 1080 Wien (AT); Edelmoser, Karl, Dr., 1230 Wien (AT); Erhartt, Lutz, Dr., 1030 Wien (AT)
(74) Vertreter: KLIMENT & HENHAPEL

(56) Entgegenhaltungen:
- EP-A- 1 104 094
- WO-A-98/19391
- WO-A-98/44626
- DE-A- 19 619 208
- US-A- 5 481 615
- TAKANO H ET AL: "Multiple-bridge PWM current-regulated power amplifier for magnetic resonance imaging system and its feasible digital control implementation" INDUSTRIAL ELECTRONICS SOCIETY, 1999. IECON '99 PROCEEDINGS. THE 25TH ANNUAL CONFERENCE OF THE IEEE SAN JOSE, CA, USA 29 NOV.-3 DEC. 1999, PISCATAWAY, NJ, USA,IEEE, US, 29. November 1999 (1999-11-29), Seiten 785-790, XP010366646 ISBN: 0-7803-5735-3

## Beschreibung

Die Erfindung bezieht sich auf ein Verfahren zur Erzeugung einer leistungsstarken einem Eingangs-Datenstrom, z.B. im Sony Consumer Standard i²s Format, folgenden Wechselspannung gemäß dem Oberbegriff des Anspruches 1.

Im Consumer Audio Bereich beispielsweise wird die Leistung für die Lautsprecher über entsprechend voluminöse Kupferdrähte Übertragen. Nebst hoher Kosten wirken diese Kabel auch als Sendeantennen hochfrequenter Störungen, wenn schaltende Verstärker, sogenannte D-Verstärker, eingesetzt werden. Innerhalb eines größeren fortschrittlichen Konzeptes wird ein D-Verstärker, dem ein digitaler Datenstrom via Lichtleiter zugeführt wird, in das Gehäuse des Lautsprechers eingebaut. Der D-Verstärker eines derartigen Lautsprechers wird mittels Netzanschluß versorgt, und hat sich elektromagnetisch mit der Umgebung zu vertragen.

Bei bekannten derartigen Lösungen ist stets eine Umsetzung des Eingangs-Datenstroms in ein analoges Signal vorgesehen, das dann verstärkt und das verstärkte Signal anschließend wieder in ein digitales Signal umgesetzt wird. Dabei ist aber ein Qualitätsverlust aufgrund der mehrmaligen Umsetzung nicht zu vermeiden.

Außerdem ist der Wirkungsgrad nicht-schaltender Analogverstärker mit ca. 50% relativ gering. Mit leistungselektronischen, bzw. schaltenden Verstärkern werden dagegen derzeit bereits über 90% erreicht. Beim D-Verstärker wird eine am Eingang anliegende Analogspannung mit einer festen Frequenz, der Schaltfrequenz des D-Verstärkers, Pulsweiten (PWM-) moduliert. Diese PWM-Spannung wird in der PWM-Endstufe des D-Verstärkers durch das abwechselnde Ein- und Ausschalten von Transistoren mit einem hohen Wirkungsgrad verstärkt. Der zweite Vorteil von leistungselektronischen, schaltenden Stromversorgungen ist die geringe Größe der reaktiven Bauelemente, wie Induktivitäten und Kondensatoren, aufgrund der gegenüber 50Hz hohen Schaltfrequenz. Die Filtergröße eines D-Verstärkers wird von der unteren Hörschwelle (15 Hz) bestimmt. Der Wirkungsgrad wird wesentlich von der Schaltfrequenz beeinflußt. Die Schaltfrequenz hat ein Vielfaches der oberen Hörschwelle (20 kHz) zu betragen.

Das Spektrum der verstärkten PWM-Spannung weist naturgemäß einen hohen schaltfrequenten Anteil und hohe Oberschwingungsanteile auf, die nun entsprechend vollständig aus dieser wieder herausgefiltert werden müssen, um an der Last eine leistungsstarke, möglichst unverzerrte Analogspannung zu erhalten. Dabei ist es notwendig, Pulsungenauigkeiten durch eine entsprechende Rückkopplung zu vermeiden.

D-Verstärker mit Analogeingang und passiven Filtern sind aus dem Stand der Technik bekannt. Die Phasendrehung eines Bandpaßfilters und die komplexe Lautsprecherlast setzen der für niedrige Verzerrungen wünschenswerten kräftigen Gegenkopplung durch Instabilitäten sehr schnell enge Grenzen.

In der WO 98/44626 wird das digitale Signal (z.B.: I2S) mit einem Modulator in ein PWM-Signal gewandelt, und dieses nun vorliegende, und in weiterer Folge verstärkte PWM-Signal mit dem vom Ausgang rückgeführten Signal verglichen. Dabei werden individuelle Signalpulse mithilfe einer "correction unit" in ihren Impulsflanken "vorkorrigiert", sodass sie nach Durchlaufen der Verstärkerstufe frei von Störungen sind. Die "correction unit" Verfügt dabei über Mittel zur Korrektur der Verzögerung einzelner Impulsflanken. Somit werden die Pulsbreiten zu einer Regelung in Form einer Vorsteuerung zur Pulsmusterkorrektur herangezogen.

In der DE 196 19 208 wird ein geschalteter Verstärker unter Verwendung eines Sigma Delta Modulators vorgeschlagen.

Ziel der Erfindung ist es, diese Nachteile zu vermeiden und ein Verfahren der eingangs erwähnten Art vorzuschlagen, das eine Verstärkung mit hohem Wirkungsgrad ermöglicht, wobei die verstärkte Spannung sehr genau dem Eingangs-Datenstrom entspricht.

Erfindungsgemäß wird dies bei einem Verfahren der eingangs erwähnten Art durch die kennzeichnenden Merkmale des Anspruches 1 erreicht. Durch die vorgeschlagenen Maßnahmen wird eine Umwandlung in ein analoges Signal vermieden und gleichzeitig sichergestellt, daß das verstärkte Signal weitestgehend dem Eingangs-Datenstrom entspricht.

Die Ableitung des verstärkten Ausgangssignales kann nach einem beliebigen Algorithmus erfolgen. Zum Beispiel kann die Ableitung eines digitalen Signals aus dem verstärkten Ausgangssignal nach dem Algorithmus einer adaptiven Delta-Modulation, wobei auch ein überlagerter Algorithmus zur Reduktion der effektiven Schaltfrequenz vorgesehen sein kann, oder nach dem einer Advanced Puls Code Modulation erfolgen. Dabei stellen die oben angegebenen Algorithmen lediglich Beispiele dar.

Ein weiteres Ziel der Erfindung ist es, eine Vorrichtung zur Durchführung des erfindungsgemäßen Verfahrens vorzuschlagen.

Ausgehend von einer Vorrichtung gemäß dem Oberbegriff des Anspruches 2 werden daher die kennzeichnenden Merkmale des Anspruches 2 vorgeschlagen.

Durch die vorgeschlagenen Maßnahmen ergibt sich ein sehr einfacher Aufbau, wobei durch die digitale Regelung ein sehr genauer Abgleich der verstärkten Spannung mit dem Eingangs-Datenstrom sichergestellt ist. Mittels eines Zeitgliedes, das in Digitaltechnik sehr leicht auszuführen ist, kann die Phasendrehung kompensiert werden. Dem Regler wird dabei der Sollwert um dieFilterlaufzeit verzögert mitgeteilt, sodaß er zeitgleich mit der rückgekoppelten, digitalisierten Ausgangsspannung eintrifft. Dadurch arbeitet der Regler stabil.

Dabei kann vorgesehen sein, daß auch eine Anpassung an die Verhältnisse aus dem dem Stellglied nachgeordneten Bereich möglich ist. Dies ist z.B. bei Audioanlagen von Vorteil. So ist es möglich für die Beschallung einer Disco die mit steigender Besucherzahl eintretende Änderung der Dämpfung auszugleichen.

Durch die Merkmale des Anspruchs 3 sinken die Anforderungen an die Energieversorgung. So können durch die vorgeschlagenen Maßnahmen mit dem Regler auch Schwankungen der Versorgungsspannung des Leistungsteiles erfaßt und ausgeregelt werden. Außerdem kann die Spannungsquelle einfacher aufgebaut sein. Der Rechenaufwand für Komparator und Regler kann eher langsam im Mikroprozessor oder schnell in einem schaltungsprogrammierbaren IC in einer fest verdrahteten Rechenschaltung realisiert sein. Bei den hohen Wandlungsgeschwindigkeiten heutiger AD-Wandler (z.B. 90MHz) ist im letzteren Fall bereits jetzt eine ausreichend kleine Schleifendurchlaufzeit realisierbar, sodaß dann auch mit dieser Reglerstruktur eine Pulsmusterkorrektur erfolgt.

Sollen auch Filterverzerrungen ausgeregelt werden, ist das Problem der Phasendrehung zu lösen, wie noch näher ausgeführt werden wird.

Bekannt sind Verfahren, wo Filterverzerrungen in Kauf genommen werden, und eine schnelle Regelung zur Pulsmustererzeugung vorgesehen ist, die ein analoges Eingangssignal benötigt.

Des Weiteren ist es möglich ein Pulsmuster zu erzeugen, wobei der digitale Eingangsdatenstrom mit hoher Kongruenz zu einer leistungsstarken PWM-Ausgangsspannung verarbeitet wird, und auf eine qualitätsreduzierende digital/analog-Wandlung verzichtet werden kann.

Für hohe Qualitätsansprüche sind eine hochwertige Energieversorgung und ein entsprechend aufwendiger D/A-Wandler (Filter) nötig.

Allerdings bemerkt der Regler Schwankungen der Versorgungsspannung erst nach der Durchlaufzeit des D/A-Wandlers oder Filters. Innerhalb der Durchlaufzeit werden alle Änderungen der Versorgungsspannung direkt als Amplitudenmodulation an die Last weitergegeben, was sich in einer unzureichenden Supply Voltage Rejection (SVR) äußert.

Vorteilhaft erscheinen Kombinationen mehrerer Regelschleifen nach den Ansprüchen 4 und 5.

So ergeben sich Einsparungen bei der Energieversorgung, und Einsparungen beim D/A-Wandler.

Akzeptable Ergebnisse werden derzeit mit einem Gegenkopplungsnetzwerk zum Ausgleich der Schaltzeitfehler und komplexen, toleranzempfindlichen und notwendigerweise mehrstufigen Filtern und einer entsprechend hohen Schaltfrequenz erzielt. Die schnelle innere Regelschleife zur Pulsmusterkorrektur der Verstärkerstufe erfordert bisher ein Analogsignal beziehungsweise die D/A-Wandlung eines digitalen Eingangs-Datenstromes. Die erforderliche Schaltfrequenz von weit über 100 kHz und die damit verbundenen schnellen Kommutierungsvorgänge in der Verstärkerstufe erschweren die Einhaltung der seit dem 2. Jänner 1996 für alle im EWR-Raum in Umlauf gebrachten Produkte verbindlichen Normen, insbesondere der EN 50081 bezüglich der Störemissionen von elektromagnetischen Feldern.

Wie noch näher ausgeführt werden wird, kann der D-Verstärker bei zumindest gleicher Qualität des Ausgangssignales gegenüber der einstufigen Lösung z.B. aufgrund der phasenversetzten Taktung von n parallel geschalteten Leistungsteilen mit dem n-tel der Schaltfrequenz betrieben werden. Die Schaltvorgänge können ohne Qualitätseinbußen langsamer ablaufen. Dadurch wird die elektromagnetische Verträglichkeit erhöht. Die Schaltverluste steigen, der Wirkungsgrad bleibt hoch verglichen mit dem A-Verstärker. Bei höheren Leistungen (derzeit etwa bei 5 kW aufwärts) können aufgrund der reduzierten Schaltfrequenz auch Entlastungsschaltungen zum Einsatz kommen, wodurch die Leistungsdichte (pro Volumen der Leistungsteile übertragbare Leistung) erhöht wird.

Außerdem können die Vorteile genützt werden, die sich durch eine Zusammenschaltung mehrerer D-Verstärkerstufen ergeben, ohne die Rechenleistung der digitalen Regeleinheit um das entsprechend Vielfache zu erhöhen. Dabei können die Verstärkerstufen relativ einfach aufgebaut sein.

Die Erfindung wird nun anhand der Zeichnung näher erläutert. Dabei zeigen:
Fig. 1 ein erstes Ausführungsbeispiel einer Verstärkeranordnung,
Fig. 2 bis 4 Ausführungsbeispiele einer Regelstrecke,
Fig. 5 bis 8 verschiedene Ausführungsformen von Verstärkeranordnungen,
Fig. 9 ein weiteres Ausführungsbeispiel für eine erfindungsgemäße Vorrichtung,
Fig. 10 und 11 weitere Ausführungsbeispiele einer Regeleinrichtung,
Fig. 12 ein Ausführungsbeispiel für einen Leistungsteil und
Fig. 13 schematisch einen Regler.

In allen Fig. sind digitale Datensträme mit schraffierten Balken und analoge Datenströme mit einfachen Strichen dargestellt.

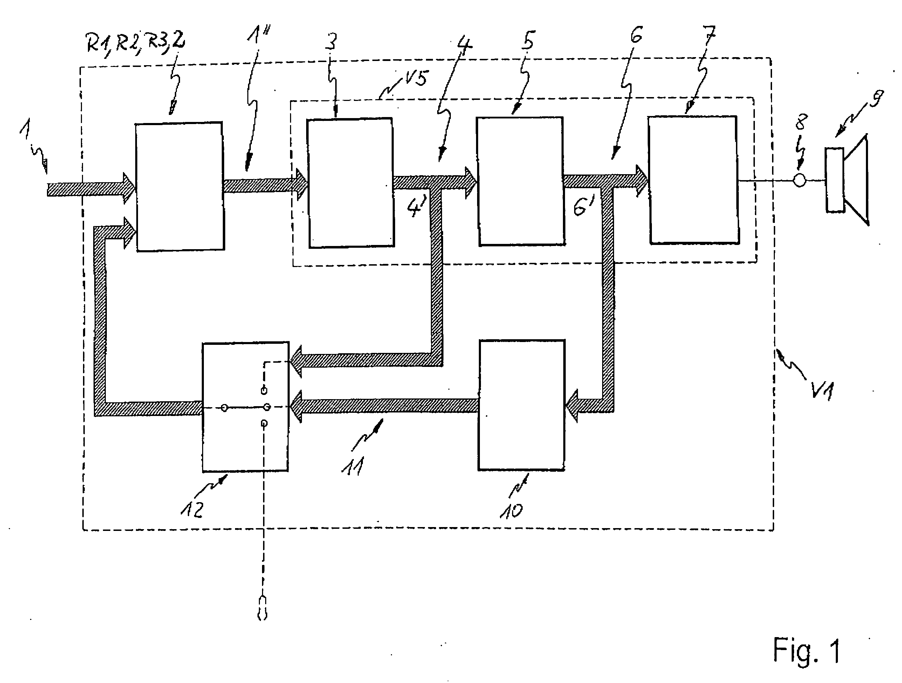

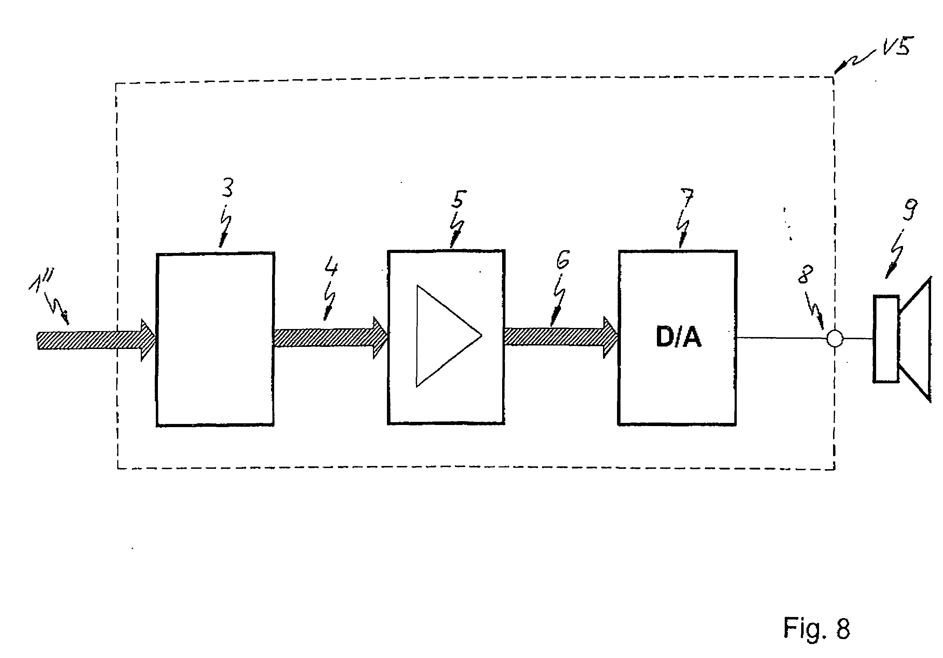

Die Verstärkeranordnung, bzw. Vorrichtung nach der Fig. 1 weist eine Verstärkerstufe V5 auf, die näher in der Fig. 8 dargestellt ist, sowie eine Regelung R1, R2, R3 oder einen Prädiktor 2, die jeweils der Verstärkerstufe V5 vorgeschaltet sind, wobei an die Verstärkerstufe V5 ein Stellglied 9, z.B. ein Lautsprecher, über eine Ausgangsklemme 8 angeschlossen ist.

Die Verstärkerstufe V5 weist im wesentlichen eine Reihenschaltung eines Kodierers 3, der einen von der Regelung R1, R2, R3 oder dem Prädiktor 2 kommenden Ausgangsdatenstrom 1" in einen digitalen Signalzug 4 umwandelt, wobei der Prädiktor 2 der Regelung R1, R2, R3 auch vorgeschaltet sein kann. Diesem Kodierer 3 ist ein D-Verstärker 5 nachgeschaltet, der den digitalen Signalzug verstärkt und an einen D/A-Wandler 7 legt, der auch als eine Filterschaltung ausgebildet sein kann.

Die Regelung R1, R2, R3, bzw. der Prädiktor 2, ist über einen Schalter 12 mit einem Abgriff 4, der zwischen dem Kodierer 3 und dem D-Verstärker 5 vorgesehen ist, oder mit einem Abgriff 6, der zwischen dem D-Verstärker und dem D/A-Wandler 7 vorgesehen ist, verbindbar. Dabei ist bei einem Abgriff nach dem D-Verstärker 5 die Vorschaltung eines Abschwächers 10 zweckmäßig. Weiters besteht auch noch die Möglichkeit, die Regelung R1, R2, R3 bzw. den Prädiktor 2 mit Signalen aus einer dem Stellglied nachgeordneten, nicht dargestellten Strecke über den Schalter 12 zu versorgen.

Beispielsweise kann der Regelung R1, R2, R3 ein Signal aus einer von einem als Stellglied 9 dienenden, in einer Disco aufgestellten Lautsprecher, bzw. aus der Disco selbst zugeführt werden. In diesem Fall können nicht nur allfällige durch die Verstärkerstufe V5 bedingten Verzerrungen ausgeregelt werden, sondern auch die durch die nachgeordnete Strecke bedingte Verzerrungen und Einflüsse, wie z.B. die von der Anzahl der im beschallten Raum befindlichen Personen abhängigen Dämpfung.

Bei dieser Ausführungsform ist die Regelung R1, R2, R3 bzw. der Prädiktor 2 der Verstärkerstufe V5 vorgeschaltet, sodaß an dieser ein gegenüber dem Eingangs-Datenstrom, der in Form von Datenwörtern mit einer vorgegebenen Anzahl von Bits vorliegt und an der Regelung R1, R2, R3 bzw. dem Prädiktor 2 anliegt, veränderter Datenstrom 1" anliegt.

Ein Prädiktor 2 benötigt höchstens zeitweilig eine Rückkopplung, und der Schalter 12 kann sich in seiner Leerstellung befinden, in der die zum Prädiktor 2 führende Leitung unterbrochen ist. Der Prädiktor 2 bildet die inverse Funktion des Systemverhaltens z.B. mathematisch ab. Er kann auch aus einem sogenannten neuronalen Netz bestehen, das Lernfähigkeit aufweist, oder auch aus einer lernfähigen Zelle bestehen. Grundlagen und Theorie der neuronalen Netze, sowie deren Aufbau sind aus der einschlägigen Literatur bekannt und stellen nicht Teil der Erfindung dar.

Der Vorteil eines Prädiktors 2 besteht in seiner Robustheit gegenüber Störungen, da er ohne ständige Rückkopplung auskommt, und in den erweiterten Möglichkeiten, die sich insbesondere bei einem lernfähigen neuronalen Netz ergeben.

Allerdings kann ein Prädiktor das Rauschen eines zeitlich veränderlichen Systems, wie thermisches Driften, Schaltzeitjitter usw. nicht kompensieren. Das zeitlich unveränderliche Übertragungsverhalten einer Regelstrecke wird mittels zeitweiliger Rückkopplung über den Schalter 12 realisiert.

Die Regelung R1, R2, R3 benötigt dagegen beständig die Rückführung des vom Punkt 4' abgegriffenen Signals oder eines vom Punkt 6' abgegriffenen, verstärkten und über den Abschwächer 10 abgeschwächten Signals 11.

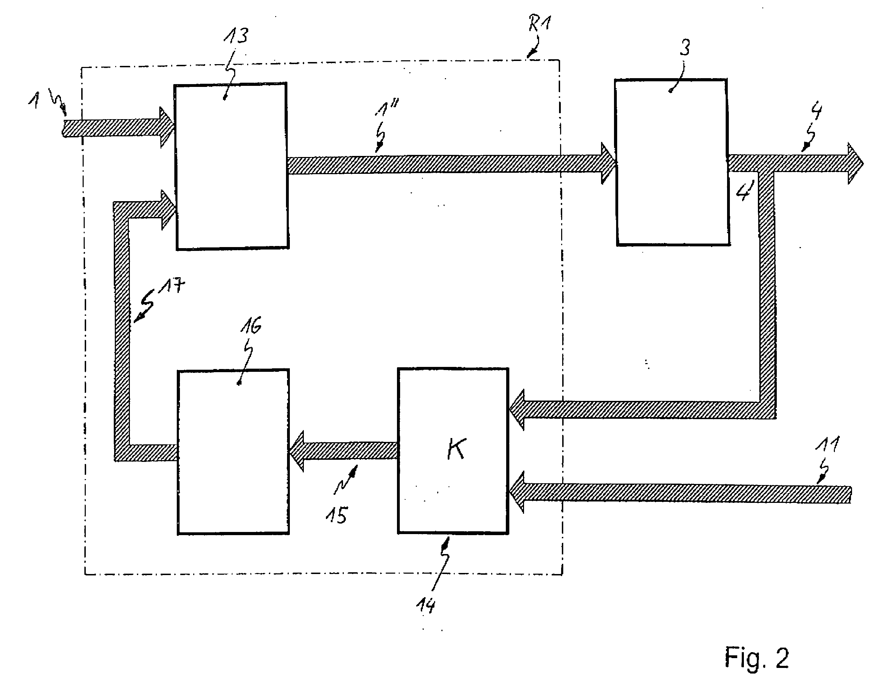

Bei der Schaltung nach der Fig. 1 kann entweder eine Regelung R1, R2, R3 vorgesehen sein, deren Aufbau verschieden gestaltet sein kann und zu denen Beispiele in den Fig. 2 bis 4 dargestellt sind, oder ein Prädiktor 2 der Verstärkerstufe V5 vorgeschaltet sein.

Die Fig. 2 zeigt den prinzipiellen Aufbau einer ersten Ausführungsform einer Regelstrecke R1. Bei dieser Ausführungsform sind eine Regeleinrichtung 13, eine Kodiereinrichtung 16 und ein Pulsfehlerkomparator 14 vorgesehen. Dabei liegen an den Eingängen der Regeleinrichtung 13 der dem Eingangs-Datenstrom entsprechende, digitale Signalzug 1, oder ein Teil eines solchen, sowie das Ausgangssignal der Kodiereinrichtung 16 an. Dieser wandelt den vom Komparator 14 kommenden digitalen Signalzug 15 in einen Fehlerdatenstrom 17 um, der die Regeleinrichtung 13 beeinflußt.

Dabei wird dem Komparator 14 ein Ausgangssignal des Kodierers 3, sowie das Signal 11 vom Abschwächer 10 (in der Fig. 2 nicht dargestellt) zugeführt, wobei der Abschwächer 10 vorzugsweise an den Punkt 6' der Verstärkerstufe angeschlossen ist. Bei dem Komparator 14 kann es sich vorzugsweise um eine XOR-Verknüpfung handeln. Bei der Kodiereinrichtung 16 kann es sich um einen zeitlich begrenzten Auf-Abwärtszähler handeln.

Die Regeleinrichtung 13 erzeugt aus dem digitalen Signalzug 1 und dem Fehlerdatenstrom 17 einen Ausgangsdatenstrom 1", der vom Kodierer 3 der Verstärkerstufe zu einem digitalen Signalzug 4 verarbeitet wird. Die Regeleinrichtung 13 kann dabei als Mischer ausgeführt sein.

Bei den hohen Wandlungsgeschwindigkeiten heutiger A/D-Wandler von z.B. 90MHz, ist die Schleifendurchlaufzeit der Regelung R1 ausreichend kurz, sodaß qualitätssteigernd eine Pulsmusterkorrektur vorgenommen werden kann.

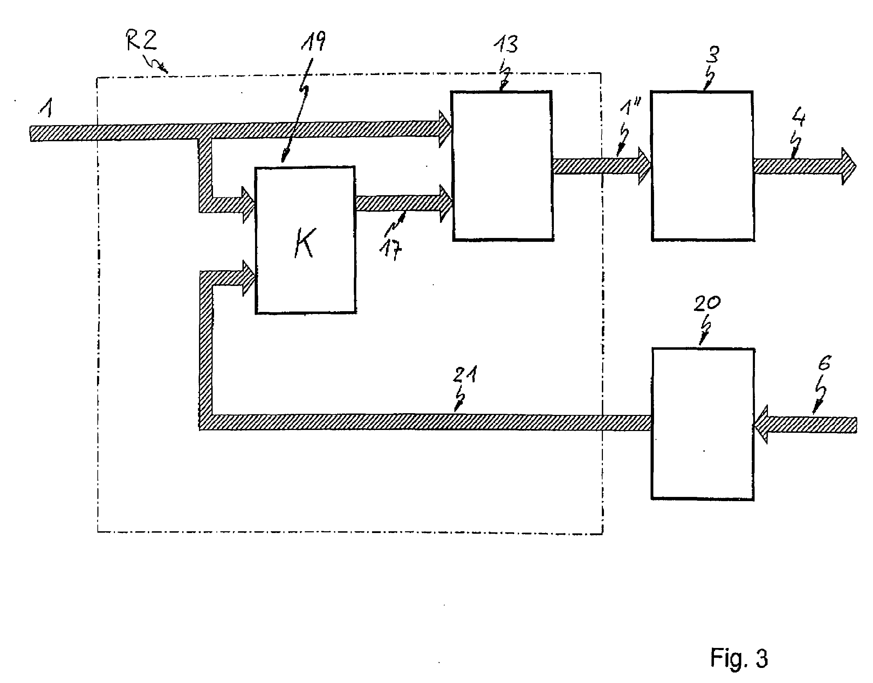

Die Regelung R2 nach der Fig. 3 weist einen Komparator 19 und eine Regeleinrichtung 13 auf. Die Regeleinrichtung 13 und der Komparator 19 verarbeiten den dem Eingangsdatenstrom entsprechenden, digitalen Signalzug 1 und den digitalen Ist-Datenstrom 21, den ein Wandler 20 liefert, der den digitalen Signalzug 6 in den Datenstrom 21 umwandelt. Dabei erzeugt der Komparator 19 einen Fehlerdatenstrom 17, der der Regeleinrichtung 13 zugeführt wird, der wiederum einen Datenstrom 1" erzeugt, der in der nachgeschalteten Verstärkerstufe verarbeitet wird, wie bereits anhand der Fig. 1 erläutert wurde.

Mit der Regelung R2 können auch Schwankungen der Versorgungsspannung des D-Verstärkers 5 erfasst und ausgeregelt werden. Dadurch kann die Spannungsquelle des D-Verstärkers 5 einfach aufgebaut werden. Der Rechenaufwand für den Komparator 19 und die Regeleinrichtung 13 kann eher langsam im Mikroprozessor, oder schnell in einer fest verdrahteten Rechenschaltung, z.B. einem schaltungsprogrammierbaren IC, realisiert sein, wobei auch eine Pulsmusterkorrektur möglich ist.

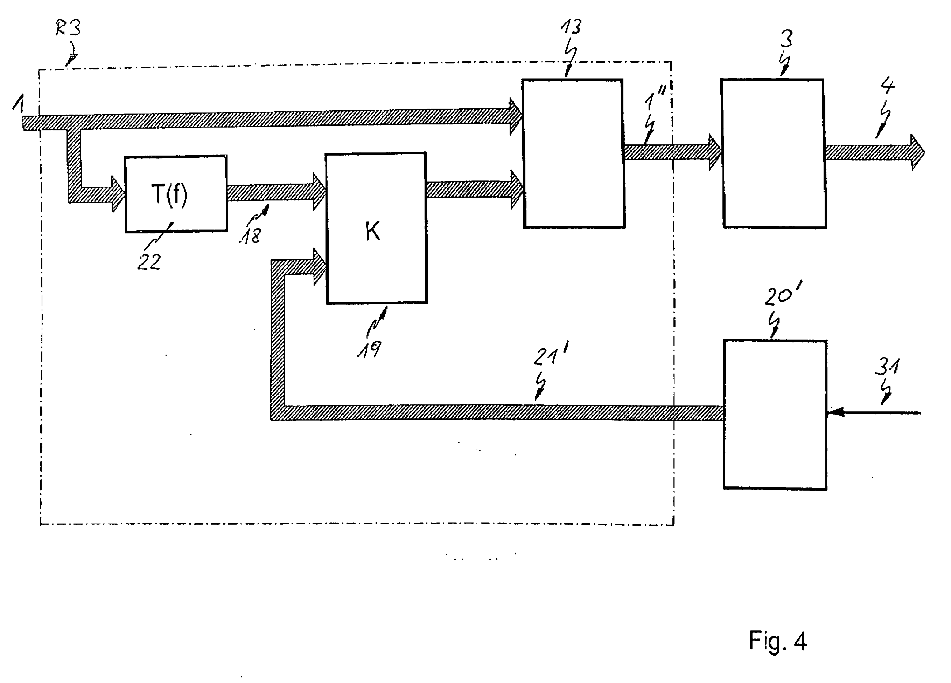

Die Regelung R3 nach der Fig. 4 unterscheidet sich gegenüber der Regelung R2 nach der Fig. 3 dadurch, dass dem Komparator 19 der dem Eingangs-Datenstrom ensprechende, digitale Signalzug 1 gegenüber der Regeleinrichtung 13 über ein Zeitglied 22 zeitlich verzögert zugeführt wird, und an dem Eingang des Wandlers 20', der analoge Signale in einen Ist-Datenstrom umwandelt, die Ausgangsspannung 31 einer oder mehrerer Verstärkerstufen anliegt.

Im Zeitglied 22 kann vorteilhafterweise eine Filtercharakteristik, oder das Streckenübertragungsverhalten der nachgeschalteten Verstärkerstufe kompensiert werden. Aufgrund des Vergleiches der Datenströme 18, den das Zeitglied 22 liefert, und 21, den der Wandler 20' liefert, die gegenüber dem digitalen Signalzug 1 um die gleiche Zeit verzögert an den Eingängen des Komparators 19 einlangen, arbeitet die Regeleinrichtung 13 stabil. Die Regelung ermöglicht den Einsatz einfacherer Filter bzw. D/A-Wandler am Ausgang der Verstärkerstufe. Die Rechenleistung für die Regeleinrichtung R3 erbringt ein Mikroprozessor.

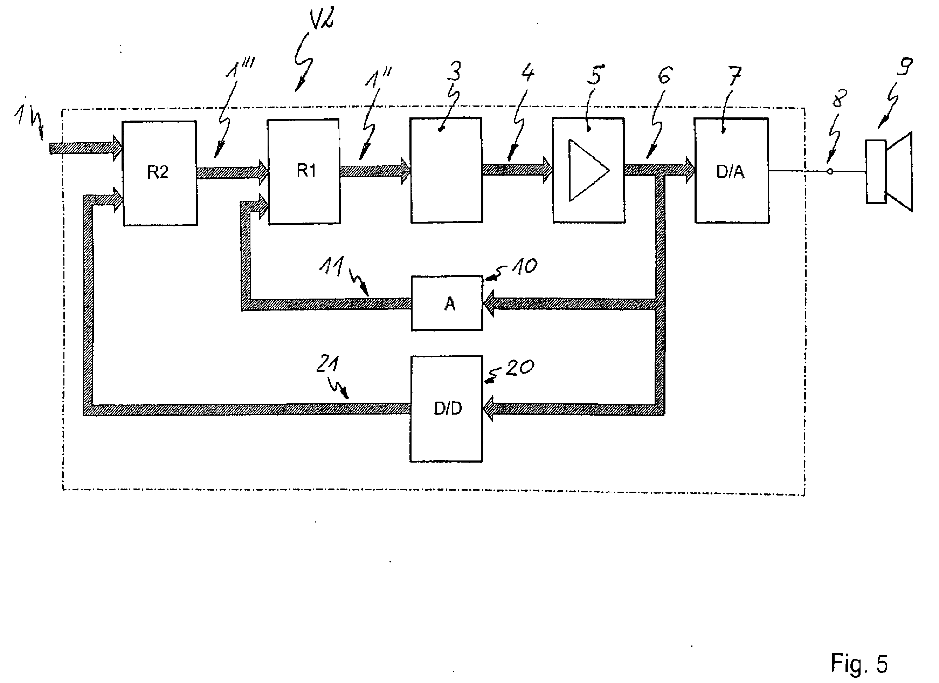

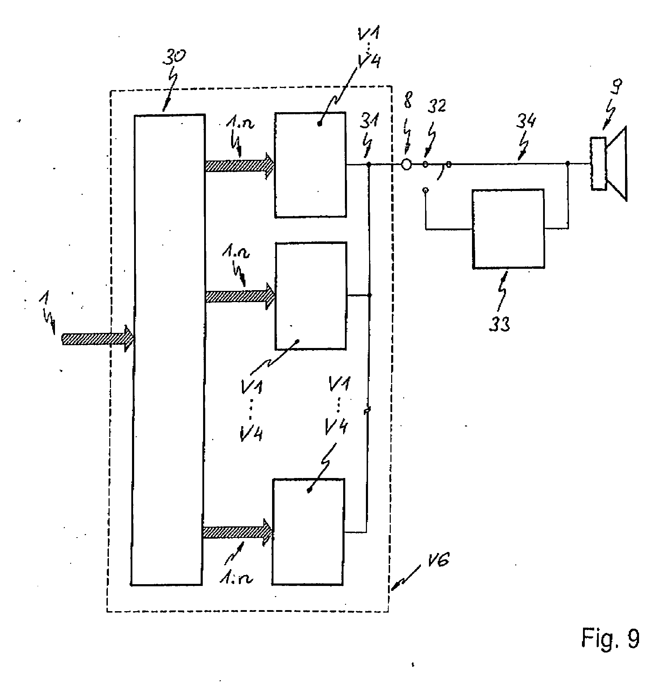

Bei den Verstärkerstufen V2 bis V4 gemäß den Fig. 5 bis 7 und V6 nach der Fig. 9 wird der erforderliche Aufwand für die Energieversorgung und Verstärkung geringer auf Kosten eines erhöhten Aufwandes an leistungsschwacher Regelelektronik, die eine immer höher werdende Qualität der Ausgangsspannung an der Last, d.h. dem Stellglied 9, gewährleistet.

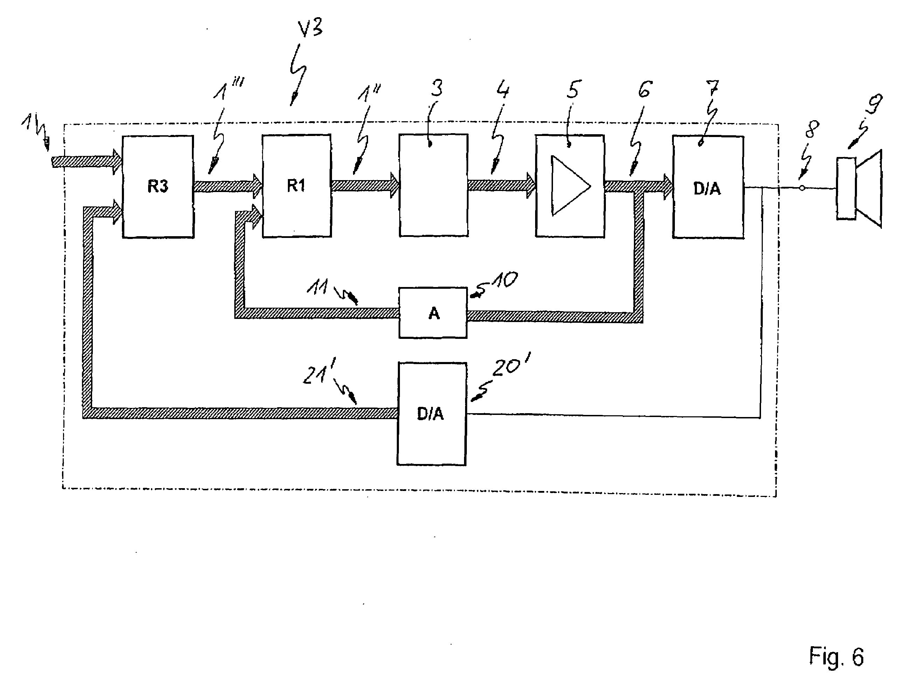

Die Verstärkerstufe V3 nach der Fig. 6 weist eine Regelung R3, eine Regelung R1, den Kodierer 3, einen D-Verstärker 5, einen D/A-Wandler 7, einen Abschwächer 10 und einen Wandler 20 auf. Dabei ist an die Eingänge des Abschwächers 10 und des Wandlers 20' die Ausgangsspannung 6 rückgekoppelt. Das Signal 11 am Ausgang des Abschwächers 10 wird der Regelung R1 zugeführt. Der Wandler 20' erzeugt aus der Ausgangsspannung 31 die Datenwörter des Istdatenstromes 21'. Der Datenstrom 21' wird der Regelung R3 zugeführt. Die Regelung R3 erzeugt aus den Datenströmen 1 und 21' den Datenstrom 1"', der der Regelung R1 zugeführt wird. In der Regelung R1 wird aus dem Datenstrom 1"' und dem Signal 11 der Datenstrom 1"' erzeugt, der vom Kodierer 3 zum digitalen Signalzug 4 verarbeitet wird, der am Ausgang des D-Verstärkers 5 verstärkt als Spannung 6 anliegt.

Die Regelung R3 kann langsamer als die Regelung R1 ausgelegt werden, und ermöglicht z.B. die Ausregelung von Schwankungen in den Versorgungsspannungen des D-Verstärkers 5 in Fig. 6.

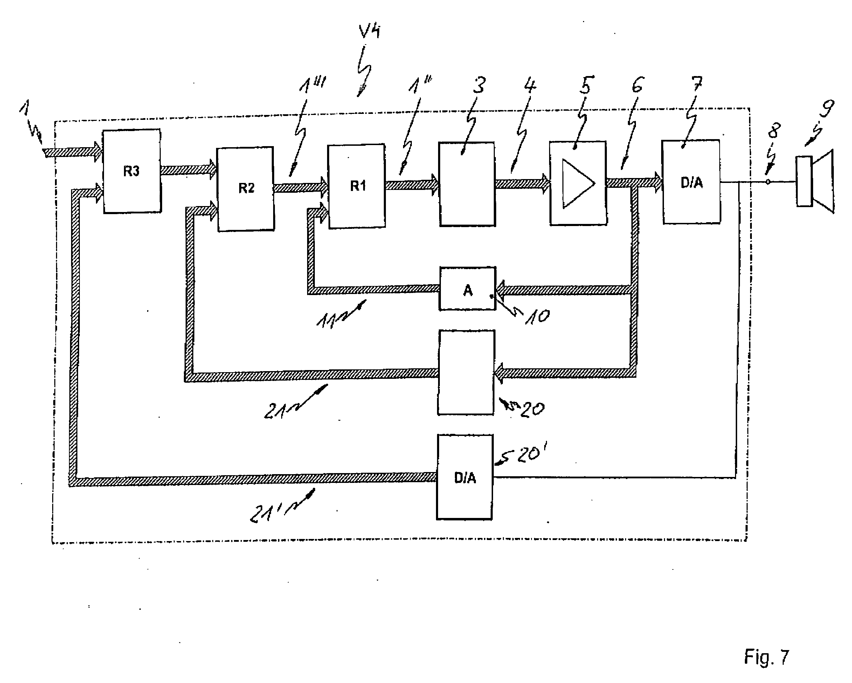

Die Verstärkerstufe V4 in der Fig. 7 unterscheidet sich von der Verstärkerstufe V3 dadurch, daß zusätzlich eine Regelung R2 vorgesehen ist, die zwischen die Regelung R3 und R1 geschaltet ist. Dabei ist die Ausgangsspannung der Verstärkerstufe V4 über den A/D-Wandler 20', der aus der Ausgangsspannung 31 einen Datenstrom 21' erzeugt, an die Regelung R3 rückgekoppelt.

Der Signalzug 6 ist einerseits über den Wandler 20, der aus dem verstärkten Signalzug 6 einen Datenstrom 21 erzeugt, an die Regelung angelegt, die der Regelung R3 nachgeschaltet ist. Weiters ist der Signalzug 6 über einen Abschwächer 10, der einen Signalzug 11 erzeugt, an die Regelung R1 rückgekoppelt, die der Regelung R2 nachgeschaltet ist.

Die Regelung R3 regelt entsprechend der Ausgangsspannung 31, und verringert dadurch die Anforderungen an den D/A-wandler 7. Das Zeitglied 22 der Regelung R3 kann in Digitaltechnik mittels eines Schieberegisters wesentlich einfacher und mit höherer Qualität ausgeführt werden, als in Analogtechnik ausgeführte, notwendigerweise mehrstufig ausgeführte Zeitglieder.

Die Funktionen und der Aufbau der einzelnen Regelungen R1, R2, R3 sind die gleichen, wie sie anhand der Fig. 2 bis 4 beschrieben wurden.

Bei der Anordnung von drei Regelstrecken R1, R2, R3 kann der Hardware-Aufwand gering gehalten werden. Dabei können durch die Rückführung der Ausgangsspannung auch Filterverzerrungen ausgeregelt werden, wodurch u.U. auf eine Filterstufe verzichtet werden kann. Außerdem können verschiedenste Filtercharakteristiken in einer digital arbeitenden Regeleinrichtung ohne wesentlichen Mehraufwand mitberücksichtigt werden.

Die Fig. 9 zeigt eine Verstärkerstufe V6, die einen Multiplexer 30, und eine Anzahl n von Verstärkerstufen aufweist, die gemäß den Verstärkerstufen V1 bis V4 ausgebildet sein können. Der Multiplexer 30 erzeugt aus dem dem Eingangsdatenstrom entsprechenden, digitalen Signalzug 1 eine Anzahl von n-Teilen von Datenströmen 1.n, wobei jeder Datenstrom 1.n einer der Verstärkerstufen V1 bis V4 zugeführt wird, wobei zweckmäßigerweise jeweils gleiche Verstärkerstufen vorgesehen sind. Die Ausgänge der n Verstärkerstufen V1 bis V4 sind mit der Ausgangsklemme 8 verbunden und speisen die Ausgangsspannung 31. Das Stellglied 9, z.B. ein Lautsprecher, ist entweder über eine Leitung 34 direkt, oder über ein zwischengeschaltetes Filter 33 an die Ausgangsklemme 8 der Verstärkerstufe V6 angeschlossen.

Bei der Ausführungsform nach der Fig. 9 kann der D-Verstärker bei zumindest gleicher Qualität des Ausgangssignales gegenüber der einstufigen Lösung, z.B. aufgrund der phasenversetzten Taktung von n parallel geschalteten D-Verstärkern 5, mit dem n-ten Teil der Schaltfrequenz betrieben werden. Die Schaltvorgänge können ohne Qualitätseinbußen langsamer ablaufen. Dadurch wird die elektromagnetische Verträglichkeit erhöht. Die Schaltverluste steigen, der Wirkungsgrad bleibt hoch, verglichen mit einem A-Verstärker. Bei höheren Leistungen von z.B. 5kW und mehr, können aufgrund der reduzierten Schaltfrequenz auch Entlastungsschaltungen zum Einsatz kommen, wodurch die Leistungsdichte (pro Volumen der Leistungsteile übertragbare Leistung) erhöht wird.

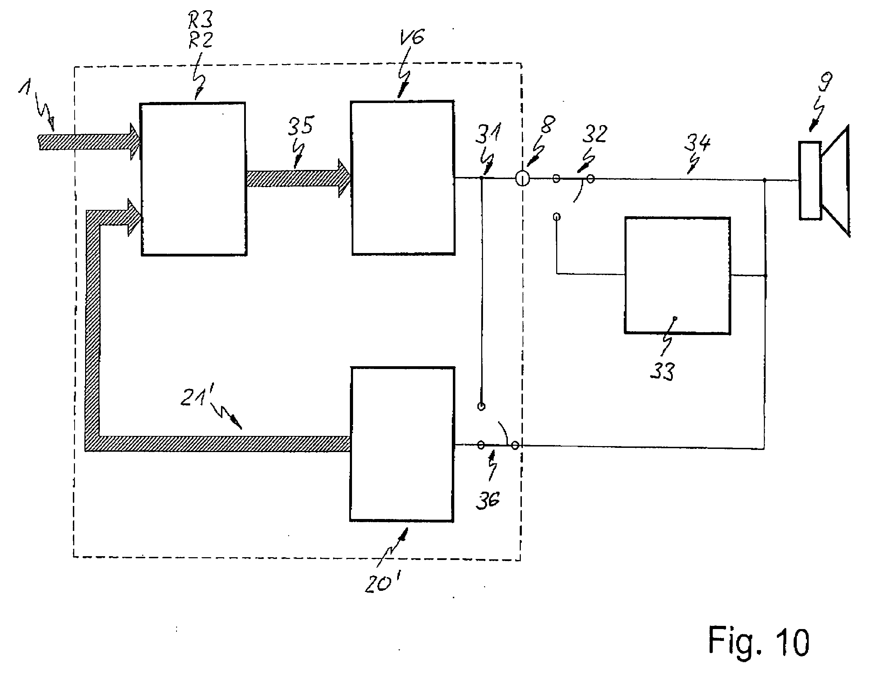

Bei der Ausführungsform nach der Fig. 10 ist einer Verstärkerstufe V6, die, wie aus der Fig. 9 zu ersehen ist, mehrere D-Verstärker umfaßt, eine Regelung R2 oder R3 (Fig. 3, Fig. 4) vorgeschaltet, die den dem Eingangs-Datenstrom entsprechenden Signalzug 1 und den Ausgangsdatenstrom 21', der vom Wandler 20' erzeugt ist, zu Datenstrom 35 verarbeitet. Die Spannung an der Ausgangsklemme 8 der Verstärkerstufe V6, oder die Spannung an der Last 9, wird mittels eines Umschalters 36, der auch weggelassen werden kann, an den Eingang des Wandlers 20' rückgekoppelt.

Bei der Ausführungsform nach der Fig. 10 können die Vorteile, die sich durch die Zusammenschaltung mehrerer D-Verstärker ergeben, genutzt werden, ohne dass die Rechenleistung der digitalen Regeleinheit um das entsprechende Vielfache erhöht werden muß. Dabei kann die Verstärkerstufe V6 aus einfachen Verstärkerstufen, z.B. Verstärkerstufen V1 (Fig. 1), aufgebaut sein.

Bei der Ausführungsform nach der Fig. 10 ist weiters ein Umschalter 32 vorgesehen, über den die Ausgangsklemme 8 wahlweise über ein Filter 33, oder direkt mit der Last 9 verbunden werden kann.

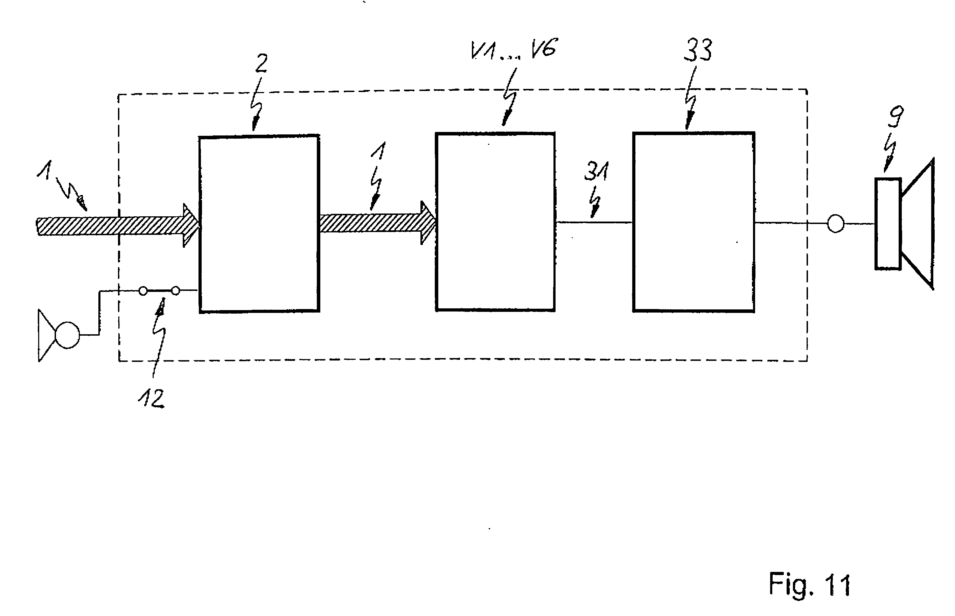

Bei der Ausführungsform nach der Fig. 11 ist einer Verstärkerstufe, bei der es sich wahlweise um eine Verstärkerstufe V1, V2, V3, V4, V5 oder V6 handeln kann, ein Prädiktor 2 vorgeschaltet, an dessen Eingang über einen Schalter 12 Signale eines Mikrofons gelegt werden können, das z.B. in einem von der Last 9, bei der es sich um einen Lautsprecher handeln kann, beschallten Raum aufgestellt ist. Dabei ist der Verstärkerstufe ein Filter 33 nachgeschaltet.

Dabei kann auch der Einfluß jener Strecke erfaßt werden, der der Last 9 nachgeordnet ist. Da der Prädiktor 2 das Verhalten der die Verstärkerstufe umfassenden Regelstrecke berücksichtigt, kann auf eine ständige Rückkopplung verzichtet werden.

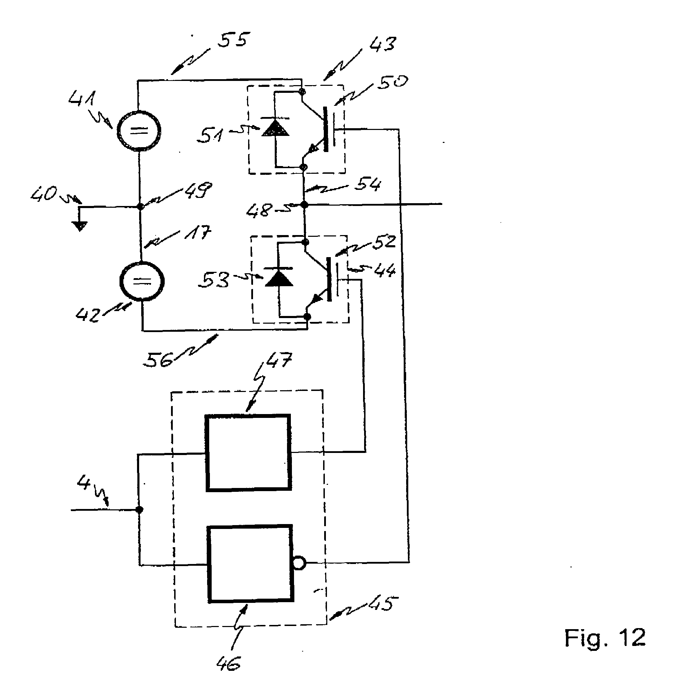

Fig. 12 zeigt das Ausführungsbeispiel für den Leistungsteil 5. Der Leistungsteil 5 wird beispielweise aus den Spannungsversorgungen 41, 42, und einer Halbbrückenanordnung 43, 44 gebildet. Die Halbbrückenanordnung ist aus einem Hauptschalter 50 und einer antiparallelen Freilaufdiode 51 und einem weiteren Hauptschalter 52 mit einer weiteren Freilaufdiode 53 gebildet.

Der Ausgang des Hauptschalters 50 ist über eine Leitung 54 mit dem Eingang des Hauptschalters 52 verbunden. Der Eingang des Hauptschalters 50 ist über die Versorgungsleitung 55 mit der Spannungsversorgung 41 und der Ausgang des Hauptschalters 52 ist über die Versorgungsleitung 56 mit der Spannungsversorgung 42 verbunden.

Die Spannungsversorgung 42 ist in Serie geschaltet. Die Leitung 57 ist am Knoten 49 mit der Leistungsmasse 40 verbunden. Zwei in Serie geschaltene Versorgungseinrichtungen 41, 42 werden mit der Halbbrückenanordnung der Leistungsschalter 43, 44 belastet. Am Mittelpunkt 48 der Halbbrückenanordnung liegt das Signal 6 an. Bezugspotential für die leistungsstarke Spannung 6 ist die Leistungsmasse 40, der am Verbindungspunkt 49 der Versorgungseinrichtungen 41, 42 angeschlossen ist. Der leistungsschwache Signalzug 4 wird der Treibereinrichtung 45 zugeführt. Ist das Signal 4 high, so wird der obere Schalter 43 mittels nicht invertierende Treibereinrichtung 47 ein- und der untere Schalter 44 mittels invertierender Treibereinrichtung 46 ausgeschaltet.

Die Spannung 6 oder 31 ist gegenüber der Masse 40 gleich der Ausgangsspannung der Versorgungseinrichtung 41. Ist das Signal 4 Low, so wird der Punkt 48 über den unteren Schalter 44 mit der Versorgungseinrichtung 42 verbunden. Die Spannung 6, 31 ist gegenüber der Leistungsmasse 40 gleich der negativen Ausgangsspannung der Versorgungseinrichtung 42. Der leistungsschwache Signalzug 4 liegt verstärkt auf den Pegeln der Versorgungseinrichtungen 41, 42 gegenüber der Leistungsmasse 40 als leistungsstarke Ausgangsspannung 6 am Halbbrückenmittelpunkt 48 an.

Beim Leistungsteil 5 handelt es sich um eine Vorrichtung, z.B. realisiert mit den Leistungshalbleitern 43, 44 in Halbbrückenanordnung, zur Herstellung von positiven und/oder negativen Spannungsimpulsen aus mindestens einer Spannungsquelle 41, 42, in dem die Stromversorgung einer Last, z.B. an der leistungsstarken Ausgangsspannung 6, taktweise verlustarm unterbrochen und/oder umgepolt wird.

Der Wirkungsgrad schaltender Verstärker wird wesentlich von der Schaltfrequenz beeinflusst. Die Schaltverluste von FET-Leistungsschaltern steigen überproportional mit der Spannungsbeanspruchung. Mindestens eine mit geringer Frequenz arbeitende D-Verstärkerstufe V1 bis V5 einer Verstärkerstufe V6 liefert Leistung für die Basslautsprecher, während die wesentlich kleinere Leistungen für die Hochtöner von einer anderen D- Verstärkerstufe V1 bis V5 der Verstärkerstufe V6 bereitgestellt werden, die mit wesentlich höherer Schaltfrequenz und kleinerer Versorgungsspannung arbeitet.

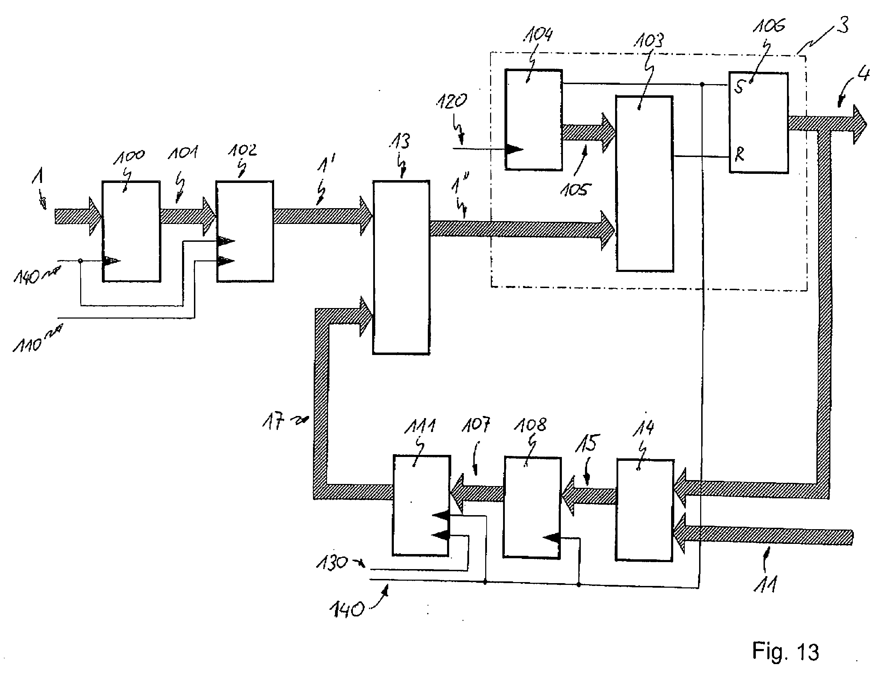

Fig. 13 zeigt beispielhaft die digitale Realisierung der Regelung R1. Die Datenwörter eines zugeführten Solldatenstromes 1, z.B. im i2s-Format, werden über z.B. den Wandler 100 und den Vorfilter 102, die auch als Decimation Filter ausgeführt sein können, eventuell seriell der Regeleinrichtung 13, etwa ein Mischer, zugeführt. Die Regeleinrichtung 13 besitzt einen Rück- oder Gegenkoppelungseingang dem der Fehlerdatenstrom 17 zugeführt wird und verarbeitet die Datenwörter der Eingangsdatenströme 1 und 17 zum Datenstrom 1''. Der Datenstrom 1" wird vom Kodierer 3 in den digitalen Signalzug 4 dergestalt umgewandelt, dass der über die Dauer einer Schaltperiode gemittelte Wert des Signalzuges 4 dem Datenstrom 1" folgt. Der digitale Signalzug 4 wird von einem schaltenden Verstärker 5 (siehe auch Fig. 12) zu der leistungsstarken Ausgangsspannung 6 verstärkt, wobei die Regeleinrichtung 13 die Schaltzeitfehler oder die Änderung der Form des Signalzuges 4 als Folge unterschiedlicher Schaltzeiten der Schalttransistoren 43, 44 des Leistungsteiles 5 kompensiert. Der digitale Signalzug 4, der dem Datenstrom 1" entspricht wird bei jeder steigenden Flanke des Clocksignales 110 vom D-Latch des Wandlers 100 übernommen. Der Wandler 100 wandelt beispielsweise die digitalen, dem Clocksignal 110 synchron Signalzüge des Solldatenstromes 1 im i2s-Format in einen parallelen oder seriellen Datenstrom 101 um, der von einem Vorfilter 102 in einen Datenstrom 1' anderer Auflösung und Synchronizität umgeformt wird.

Dieser Datenstrom 1' ist zum Taktsignal 140 synchron, beispielsweise 176kHz. Dies ist auch die Synchronizität des Kompensationsdatenstromes 17, der aus dem Vergleich des digitalen Signalzuges 4 mit der leistungsstarken Ausgangsspannung 6 gewonnen wird. Der Kompensationsdatenstrom 17 wird vom Summierer 111 erzeugt, der die vom Auf-Abwärtszähler 108 digitalisierten Werte der Pulsbreiten des Fehlersignals 15 vorzeichenrichtig addiert. Mit dem Zähler 108 lässt sich ein auf die Schaltperiode der Schaltfrequenz zeitlich begrenzter Integrator realisieren.

Die Schaltfrequenz des D-Verstärkers 5 wird vom Taktsignal 120 abgeleitet, das dem Zähler 104 des Kodierers 3 zugeführt wird. Der Zähler 104 erzeugt den schaltfrequenten Takt 140, mit dem der Zähler 108 gesteuert bzw. rückgesetzt wird. Der Ausgangsdatenstrom 107 des Auf-Abwärtszählers 108 (bzw. Fehlerpulsbreitendigitalisierer) ist zum Takt 140 synchron. Das Fehlerpulsbreitensignal 15 wird vom Komparator 14, hier z.B. als XOR-Gatter realisiert, erzeugt, dem der digitale Signalzug 4 und die digitale Ausgangsspannung 11 vom Abschwächer 10 zugeführt wird, an den eingangsseitig die leistungsstarke Ausgangsspannung 6 rückgekoppelt ist. Das Signal 15 am Ausgang des Komparators 14 ist nur für die Zeiten high, in denen seine Eingänge, also das Signal 4 und die leistungsstarke Ausgangsspannung 6, unterschiedliche Zustände aufweisen. Die dem Takt 140 synchronen Datenströme 1' und 17 werden in der Regeleinrichtung 13 (z.B. ein Mischer) addiert, der den Datenstrom 1" erzeugt.

Die Wörter des Datenstromes 1'' werden im Komparator 103 mit den Werten des Datenstromes 105, der vom Zähler 104 erzeugt wird, auf Gleichheit untersucht. Der Zähler 104 und das RS-Flip Flop 106 werden vom Takt 140 gesteuert (rückgesetzt). Mittels Zähler 104, Komparator 103, RS-FlipFlop 106 und Takt 120 wird eine PWM-Modulation des Datenstromes 1" vorgenommen.

## Patentansprüche

1. Verfahren zur Erzeugung einer durch Schalten verstärkten leistungsstarken, in Form und Amplitude einem digitalen Eingangs-Datenstrom folgenden Wechselspannung, bei dem der Eingangsdatenstrom verstärkt wird, **dadurch gekennzeichnet, dass** der Eingangs-Datenstrom in einen digitalen Signalzug (1) umgewandelt und dieser Signalzug (1) einer Regeleinrichtung (13) zugeführt wird, und ein digitales Signal (4), das vom Ausgangssignal der Regeleinrichtung (13) abhängt, durch Schalten verstärkt wird, wobei aus dem verstärkten Ausgangssignal (6) ein digitales Signal (21, 21') rückgekoppelt und mit dem digitalen Signalzug (1) mithilfe eines Komparators (19) verglichen wird, und das durch den Komparator (19) ermittelte, digitale Differenzsignal der Regeleinrichtung (13) zugeführt wird, wobei der digitale Signalzug (1) dem Komparator (19) als ein, gegenüber dem digitalen Signalzug (1) gegebenenfalls verzögerter, digitaler Signalzug (18) zugeführt wird.

2. Vorrichtung zur Erzeugung einer verstärkten leistungsstarken, in Form und Amplitude einem digitalen Eingangs-Datenstrom folgenden Wechselspannung mittels einer D-Verstärkerstufe bestehend aus einem D-Verstärker (5) mit Spannungsversorgung und mindestens einem Schalttransistor (43, 44), einem angeschlossenen D/A-Wandler und einer daran angeschlossenen Last, **dadurch gekennzeichnet, dass** eine erste, digital arbeitende Regelung (R3) vorgesehen ist, die ein Zeitglied (22), einen ersten Komparator (19) und eine erste Regeleinrichtung (13) aufweist, wobei ein erster Eingang des ersten Komparators (19) mit einem dem Eingangs-Datenstrom entsprechenden, digitalen Signalzug (1) über das Zeitglied (22) beaufschlagt ist, ein zweiter Eingang des ersten Komparators (19) mit einem aus dem Ausgangssignal (6) des D-Verstärkers (5) rückgekoppelten, digitalen Signal (21, 21') beaufschlagt ist, und der Ausgang des ersten Komparators (19) mit der ersten Regeleinrichtung (13) verbunden ist, wobei das Zeitglied (22) den digitalen Signalzug (1) dem ersten Komparator (19) gegenüber der ersten Regeleinrichtung (13) gegebenenfalls verzögert zuführt.

3. Vorrichtung nach Anspruch 2, **dadurch gekennzeichnet, dass** der zweite Eingang des ersten Komparators (19) über einen A/D-Wandler (20) an den Ausgang eines dem D-Verstärker (5) nachgeschalteten D/A-Wandlers (7) angeschlossen ist.

4. Vorrichtung nach Anspruch 2 oder 3, **dadurch gekennzeichnet, dass** zusätzlich eine zweite, digital arbeitende Regelung (R1) vorgesehen ist, die einen zweiten Komparator (14) und eine zweite Regeleinrichtung (13) aufweist, wobei ein erster Eingang der zweiten Regeleinrichtung (13) mit dem Ausgang der ersten Regeleinrichtung (13) verbunden ist, und ein erster Eingang des zweiten Komparators (14) mit einem vom Ausgangssignal (1") der zweiten Regeleinrichtung (13) abgeleiteten, digitalen Signalzug (4) beaufschlagt ist, ein zweiter Eingang des zweiten Komparators (14) mit einem dem Ausgangs-Signal des D-Verstärkers (5) entsprechenden, digitalen Signal (11) beaufschlagt ist, und der Ausgang des zweiten Komparators (14) über einen Kodierer (16) mit einem zweiten Eingang der zweiten Regeleinrichtung (13) verbunden ist.

5. Vorrichtung nach Anspruch 4, **dadurch gekennzeichnet, dass** der zweite Eingang des zweiten Komparators (14) mit dem Ausgang des D-Verstärkers (5) über einen Abschwächer (10) verbunden ist.

## Claims

1. A method for generating a powerful alternating voltage which is amplified by switching and follows a digital input data stream in respect of shape and amplitude, in which the input data stream is amplified, **characterized in that** the input data stream is converted into a digital signal train (1), and said digital signal train (1) is supplied to a control device (13), and a digital signal (4) which depends on the output signal of the control device (13) is amplified by switching, with a digital signal (21, 21') being fed back from the amplified output signal (6) and being compared with the digital signal train (1) by means of a comparator (19), and the digital differential signal which is determined by the comparator (19) is supplied to the control device (13), with the digital signal train (1) being supplied to the comparator (19) as a digital signal train (18) which is optionally delayed in relation to the digital signal train (1).

2. An apparatus for generating an amplified powerful alternating voltage which follows a digital input data stream in respect of shape and amplitude by means of a D-class amplification stage consisting of a D-class amplifier (5) with voltage supply and at least one switching transistor (43, 44), a connected digital-to-analog converter and a load connected thereto, **characterized in that** a first, digitally operating control (R3) is provided which comprises a time function element (22), a first comparator (19) and a first control device (13), with a first input of the first comparator (19) being supplied with a digital signal train (1) corresponding to the input data stream via the time function element (22), a second input of the first comparator (19) with a digital signal (21, 21') fed back from the output signal (6) of the D-class amplifier (5), and the output of the first comparator (19) being connected with the first control device (13), with the time function element (22) supplying the digital signal train (1) to the first comparator (19) in an selectively delayed manner in relation to the first control device (13).

3. An apparatus according to claim 2, **characterized in that** the second input of the first comparator (19) is connected via an analog-to-digital converter (20) to the output of a digital-to-analog converter (7) which is connected in outgoing series to the D-class amplifier (5).

4. An apparatus according to claim 2 or 3, **characterized in that** a second, digitally operating control (R1) is additionally provided, comprising a second comparator (14) and a second control device (13), with a first input of the second control device (13) being connected with the output of the first control device (13) and a first input of the second comparator (14) being supplied with a digital signal train (4) which is derived from the output signal (1") of the second control device (13), a second input of the second comparator (14) being supplied with a digital signal (11) corresponding to the output signal of the D-class amplifier (5), and the output of the second comparator (14) being connected via an encoder (16) with a second input of the second control device (13).

5. An apparatus according to claim 4, **characterized in that** the second input of the second comparator (14) is connected with the output of the D-class amplifier (5) via an attenuator (10).

## Revendications

1. Procédé pour la production d'une tension de courant alternatif puissante amplifiée par commutation, suivant par la forme et l'amplitude un flux de données d'entrée numérique, dans lequel le flux de données d'entrée est amplifié, **caractérisé en ce que** le flux de données d'entrée est transformé en un train de signaux numérique (1) et ce train de signaux (1) est amené à un dispositif de régulation (13), et un signal numérique (4) dépendant du signal de sortie du dispositif de régulation (13) est amplifié par commutation, dans lequel, à partir du signal de sortie amplifié (6), un signal numérique (21, 21') est renvoyé et comparé avec le train de signaux numérique (1) à l'aide d'un comparateur (19), et le signal différentiel numérique déterminé par le comparateur (19) est amené au dispositif de régulation (13), le train de signaux numérique (1) étant amené au comparateur (19) sous la forme d'un train de signaux numériques (18) différé éventuellement par rapport au train de signaux numérique (1).

2. Dispositif pour la production d'une tension de courant alternatif puissante amplifiée par commutation, suivant par la forme et l'amplitude un flux de données d'entrée numérique au moyen d'un étage d'amplificateur numérique composé d'un amplificateur numérique (5) avec une alimentation électrique et au moins un transistor de commutation (43, 44), un convertisseur numérique-analogique connecté et une charge connectée à celui-ci, **caractérisé en ce qu'**il est prévu une première régulation (R3) à fonctionnement numérique, qui comprend un élément temporisateur (22), un premier comparateur (19) et un premier dispositif de régulation (13), une première entrée du premier comparateur (19) étant exposée à un train de signaux numérique (1) correspondant au flux de données d'entrée par l'intermédiaire de l'élément temporisateur (22), une deuxième entrée du premier comparateur (19) étant exposée à un signal numérique (21, 21') renvoyé à partir du signal de sortie (6) de l'amplificateur numérique (5), et la sortie du premier comparateur (19) étant reliée au premier dispositif de régulation (13), l'élément temporisateur (22) amenant le train de signaux numérique (1) au premier comparateur (19) avec éventuellement une temporisation par rapport au premier dispositif de régulation (13).

3. Dispositif selon la revendication 2, **caractérisé en ce que** la deuxième entrée du premier comparateur (19) est reliée par l'intermédiaire d'un convertisseur analogique-numérique (20) à la sortie d'un convertisseur numérique-analogique (7) monté en aval de l'amplificateur numérique (5).

4. Dispositif selon la revendication 2 ou 3, **caractérisé en ce qu'**il est prévu en outre une deuxième régulation (R1) à fonctionnement numérique, qui comprend un deuxième comparateur (14) et un deuxième dispositif de régulation (13), dans lequel une première entrée du deuxième dispositif de régulation (13) est reliée à la sortie du premier dispositif de régulation (13), et une première entrée du deuxième comparateur (14) est exposée à un train de signaux numérique (4) dérivé du signal de sortie (1") du deuxième dispositif de régulation (13), une deuxième entrée du deuxième comparateur (14) est exposée à un signal numérique (11) correspondant au signal de sortie de l'amplificateur numérique (5) et la sortie du deuxième comparateur (14) est reliée par l'intermédiaire d'un codeur (16) à une deuxième entrée du deuxième dispositif de régulation (13).

5. Dispositif selon la revendication 4, **caractérisé en ce que** la deuxième entrée du deuxième comparateur (14) est reliée à la sortie de l'amplificateur numérique (5) par l'intermédiaire d'un atténuateur (10).
